(19) Europäisches Patentamt
European Patent Office
Office européen des brevets

(11) **EP 3 605 588 A1**

(12) **EUROPEAN PATENT APPLICATION**
published in accordance with Art. 153(4) EPC

(43) Date of publication:
**05.02.2020 Bulletin 2020/06**

(51) Int Cl.:
*H01L 21/304* $^{(2006.01)}$     *B24B 37/00* $^{(2012.01)}$
*C09K 3/14* $^{(2006.01)}$

(21) Application number: **18775838.8**

(22) Date of filing: **14.03.2018**

(86) International application number:
**PCT/JP2018/009865**

(87) International publication number:
**WO 2018/180479 (04.10.2018 Gazette 2018/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.03.2017 JP 2017072667**

(71) Applicants:
• **Fujimi Incorporated**
  **Kiyosu-shi, Aichi 452-8502 (JP)**
• **Toagosei Co., Ltd.**
  **Minato-ku**
  **Tokyo 105-8419 (JP)**

(72) Inventors:
• **NUMATA, Keisuke**
  **Kiyosu-shi**
  **Aichi 452-8502 (JP)**
• **TSUCHIYA, Kohsuke**
  **Kiyosu-shi**
  **Aichi 452-8502 (JP)**
• **TANIGUCHI, Megumi**
  **Kiyosu-shi**
  **Aichi 452-8502 (JP)**
• **TAKEMOTO, Takayuki**
  **Nagoya-shi**
  **Aichi 455-0026 (JP)**

(74) Representative: **Grünecker Patent- und Rechtsanwälte**
  **PartG mbB**
  **Leopoldstraße 4**
  **80802 München (DE)**

(54) **POLISHING COMPOSITION**

(57)     Provided is a polishing composition by which the amount of edge roll off can be effectively reduced. The polishing composition provided by the present invention contains an abrasive, a basic compound, a nitrogen-containing water-soluble polymer and water. The nitrogen-containing water-soluble polymer does not have a N-H bond in the molecule.

## Description

### Technical Field

The present invention relates to a polishing composition. The present application claims priority on the basis of Japanese Patent Application No. 2017-72667, which was filed on 31 March 2017, and the entire contents of that application are incorporated herein by reference.

### Background Art

Silicon wafers, which are used as constituent elements of semiconductor products, are generally finished to a high quality mirror finish by means of a lapping step and a polishing step. This type of polishing step typically includes a stock polishing step and a final polishing step. For example, Patent Literature 1 to 4 are given as examples of technical documents relating to polishing compositions.

Citation List

Patent Literature

    Patent Literature 1: WO 2011/135949
    Patent Literature 2: WO 2012/005289
    Patent Literature 3: Japanese Patent Application Publication No. 2016-124943
    Patent Literature 4: Japanese Patent Application Publication No. 2014-216464

### Summary of Invention

Technical Problem

The inventors of the present invention studied incorporating basic compounds in polishing compositions used for polishing silicon wafers and the like in order to improve polishing removal rate. However, incorporating a basic compound in a polishing composition can improve the polishing removal rate, but near-edge parts, which are the outer peripheral parts of a silicon wafer, are polished more than the central part of the silicon wafer in some cases. This can lead to concerns regarding the thickness of outer peripheral parts being undesirably reduced after polishing (the occurrence of edge roll off).

The present invention takes into account the above-mentioned circumstances. The purpose of the present invention is to provide a polishing composition by which the amount of edge roll off after polishing can be effectively reduced.

Solution to Problem

Provided by the present invention is a polishing composition. This polishing composition contains an abrasive, a basic compound, a nitrogen-containing water-soluble polymer and water. The nitrogen-containing water-soluble polymer does not have a N-H bond in the molecule. According to this feature, it is possible to effectively reduce the amount of edge roll off after polishing.

In a preferred embodiment of the polishing composition disclosed here, the nitrogen-containing water-soluble polymer has a constituent unit A in the main chain. The constituent unit A includes at least one structure selected from a group consisting of an amide structure, an azole structure, a lactam structure, a morpholine structure and an amidine structure. This nitrogen-containing water-soluble polymer having constituent unit A in the main chain can effectively contribute to a reduction in the amount of edge roll off.

In a preferred embodiment of the polishing composition disclosed here, the proportion of the amide structure relative to the total mass of the constituent unit A is 30 mass% or less. If the proportion of an amide structure in constituent unit A falls within the range mentioned above, the above-mentioned edge roll off reduction effect can be more effectively exhibited.

In a preferred embodiment of the polishing composition disclosed here, the nitrogen-containing water-soluble polymer is polyacryloylmorpholine. This nitrogen-containing water-soluble polymer can effectively contribute to a reduction in the amount of edge roll off.

In a preferred embodiment of the polishing composition disclosed here, the nitrogen-containing water-soluble polymer is polyvinylimidazole. This nitrogen-containing water-soluble polymer can effectively contribute to a reduction in the amount of edge roll off.

In a preferred embodiment of the polishing composition disclosed here, the abrasive is silica particles. By using silica particles as the abrasive, the edge roll off reduction effect achieved by the nitrogen-containing water-soluble polymer can be more advantageously exhibited.

The polishing composition disclosed here can be advantageously used for polishing silicon, for example, polishing silicon that has been subjected to lapping. A particularly preferred example of a polishing application is stock polishing of silicon.

## Description of Embodiments

Preferred embodiments of the present invention will now be explained. Moreover, matters which are necessary for carrying out the invention and which are matters other than those explicitly mentioned in the present specification are matters that a person skilled in the art could understand to be matters of design on the basis of the prior art in this technical field. The present invention can be carried out on the basis of the matters disclosed in the present specification and common general technical knowledge in this technical field.

<Nitrogen-containing water-soluble polymer>

The polishing composition disclosed here contains a nitrogen-containing water-soluble polymer that does not have a N-H bond in the molecule. Here, the term "water-soluble polymer" means a water-soluble compound having identical repeating constituent units (a homopolymer) or different repeating constituent units (a copolymer). The nitrogen-containing water-soluble polymer is typically a compound having a weight average molecular weight (Mw) of 5000 or more. By incorporating a nitrogen-containing water-soluble polymer that does not have a N-H bond in the molecule in the polishing composition, it is possible to effectively reduce the amount of edge roll off after polishing. The reason why such an advantageous effect can be achieved is thought to be as follows. That is, because the nitrogen-containing water-soluble polymer does not have a N-H bond, which exhibits hydrophilic properties, in the molecule, high adsorption to a hydrophobic polishing object can generally be achieved. As a result, the nitrogen-containing water-soluble polymer is suitably adsorbed to outer peripheral parts of a polishing object during polishing, which leads to the outer peripheral parts being protected and not excessively abraded. It is thought that this contributes to a reduction in the amount of edge roll off. However, it should not be interpreted that this is the only reason why such an advantageous effect can be achieved.

In the art disclosed here, the nitrogen-containing water-soluble polymer is not particularly limited as long as the polymer has one or more nitrogen (N) atoms in the molecule and the nitrogen atom(s) are atoms that do not have a N-H bond. For example, the nitrogen-containing water-soluble polymer may be a polymer that has, in the main chain, a constituent unit A not having a N-H bond. This constituent unit A includes main chain-constituting carbon atoms, which constitute the main chain of the nitrogen-containing water-soluble polymer, and a nitrogen-containing structure that includes a nitrogen atom. The nitrogen-containing water-soluble polymer disclosed here may contain one type of constituent unit A, or two or more types of constituent unit A. This may be a compound in which the number of main chain-constituting carbon atoms in the constituent units A is not particularly limited, but is typically 2 to 10, preferably 2 to 8, more preferably 2 to 6, and further preferably 2 to 4, for example 2 or 3. One or two or more hydrogen atoms bonded to the main chain-constituting carbon atoms may each independently be substituted with substituent groups other than hydrogen atoms, such as methyl groups, phenyl groups, benzyl groups, halogen groups, difluoromethyl groups, trifluoromethyl groups and cyano groups. Here, halogen groups are, for example, F, Cl, Br or the like.

The nitrogen-containing structure is preferably directly bonded to a main chain-constituting carbon atom. The nitrogen-containing structure is not particularly limited as long as the polymer has one or more nitrogen atoms and the nitrogen atom(s) are atoms that do not have a N-H bond. For example, the nitrogen-containing structure can be one or two or more structures selected from among amide structures, imide structures, aziridine structures, azetidine structures, azeto structures, azolidine structures, azole structures, azinane structures, pyridine structures, azepane structures, azepine structures, lactam structures, morpholine structures, quinoline structures, indole structures and amidine structures not having a N-H bond. Of these, a constituent unit A having any of an amide structure, an azole structure, a lactam structure, a morpholine structure and an amidine structure is preferred. Here, the term "amide structure" means a structure having a double bond between an oxygen atom and a carbon atom that is adjacent to a nitrogen atom, and is typically a structure represented by - C(=O)-N-. The term "azole structure" means a heterocyclic 5-membered ring structure having one or more nitrogen atoms, and encompasses a structure that is substituted with a heteroatom other than a nitrogen atom. Examples of the heteroatom other than a nitrogen atom include an oxygen (O) atom and a sulfur (S) atom. Azole structures can encompass, for example, pyrrole structures, imidazole structures, pyrazole structures, isothiazole structures, isooxazole structures and furazan structures. The term "lactam structure" means a structure containing -C(=O)-NR$^a$- in a part of a heterocycle, and can encompass $\alpha$-lactam structures, $\beta$-lactam structures, $\gamma$-lactam structures, $\delta$-lactam structures, $\varepsilon$-caprolactam structures, and the like. The term "amidine structure" means a structure represented by -C(=NR$^a$)-NR$^b$R$^c$. By carrying out polishing using a nitrogen-containing water-soluble polymer having, in the main chain, a constituent unit A that includes this type of nitrogen-containing structure, the amount of edge roll off on a polished surface can be effectively reduced.

In a preferred embodiment, the proportion of an amide structure (CON: formula weight 42) relative to the total mass of the constituent unit A is approximately 50 mass% or less. The proportion of an amide structure is preferably 40 mass% or less, more preferably 35 mass% or less, and further preferably 30 mass% or less. If the proportion of an amide structure in the constituent unit A falls within such a range, high adsorption of the nitrogen-containing water-soluble polymer to a polishing object can be achieved. As a result, the edge roll off reduction effect mentioned above can be more effectively achieved. The lower limit for the proportion of an amide structure is not particularly limited, but can be, for example, 5 mass% or more. From perspectives such as easily dissolving the nitrogen-containing water-soluble polymer in water, the proportion of an amide structure may be, for example, 10 mass% or more, and typically 20 mass% or more. In addition, the proportion of an amide structure may be 0 mass%. That is, the constituent unit A may contain substantially no amide structure. The art disclosed here can be advantageously carried out in an embodiment whereby the proportion of an amide structure in the constituent unit A is 0 to 40 mass%, for example 0 to 35 mass%, and typically 25 to 30 mass%.

The constituent unit A is preferably derived from a polymerizable monomer. That is, the nitrogen-containing water-soluble polymer disclosed here is preferably a polymer obtained by polymerizing or copolymerizing a monomer component containing one or two or more types of polymerizable monomer. The polymerizable monomers preferably have a polymerizable group having an ethylenically unsaturated bond. Here, the term "ethylenically unsaturated bond" means a carbon-carbon double bond capable of radical polymerization. A hydrogen atom bonded to a carbon atom that constitutes an ethylenically unsaturated bond may be substituted with a substituent group that contains a nitrogen-containing structure mentioned above. A polymerizable group having an ethylenically unsaturated bond may be a part of a functional group such as an acryloyl group, and examples thereof include vinyl groups, vinylidene groups and vinylene groups. Preferred is a polymerizable monomer in which a hydrogen atom bonded to a carbon atom that constitutes the polymerizable group is substituted by a substituent group that contains a nitrogen-containing structure mentioned above.

In the art disclosed here, a particularly preferred example of the constituent unit A is a unit derived from a polymerizable monomer a represented by general formula (1) below. The nitrogen-containing water-soluble polymer disclosed here is preferably a polymer obtained by polymerizing or copolymerizing a monomer component containing monomer a represented by general formula (1) below.

Monomer a represented by general formula (1):

$$CH_2=CR^1X \qquad (1).$$

In general formula (1) above, R$^1$ is a hydrogen atom, a methyl group, a phenyl group, a benzyl group, a chloro group, a difluoromethyl group, a trifluoromethyl group or a cyano group. Of these, a hydrogen atom, a methyl group or a phenyl group is preferred. X is a group selected from among an amide group, an amidine group and a heterocyclic group containing a nitrogen atom, and X does not have a N-H bond.

In cases where X in the monomer a is an amide group, that is, a group represented by -C(=O)-NR$^2$R$^3$, R$^2$ and R$^3$ may be groups selected from among optionally substituted alkyl groups, alkenyl groups, alkynyl groups, aralkyl groups, alkoxy groups, alkoxyalkyl groups, alkylol groups, acetyl groups and aromatic groups. The total number of carbon atoms in the optionally substituted alkyl groups, alkenyl groups, alkynyl groups, aralkyl groups, alkoxy groups, alkoxyalkyl groups, alkylol groups and acetyl groups is 1 to 40. This total number of carbon atoms is preferably 1 to 24, more preferably 1 to 14, and further preferably 1 to 10. The total number of carbon atoms in the alkyl groups, alkenyl groups, alkynyl groups, aralkyl groups, alkoxy groups, alkoxyalkyl groups, alkylol groups and acetyl groups, excluding substituent groups, is 1 to 18. This number of carbon atoms is preferably 1 to 8, and more preferably 1 to 4. The optionally substituted alkyl groups, alkenyl groups, alkynyl groups, aralkyl groups, alkoxy groups, alkoxyalkyl groups, alkylol groups and acetyl groups may be chain-like or cyclic, but chain-like groups are preferred. Here, the term "chain-like" means straight chain-like or branched. The aromatic groups are optionally substituted aryl groups. The total number of carbon atoms in the aromatic groups is 6 to 60. This total number of carbon atoms is preferably 6 to 36, more preferably 6 to 24, and further preferably 6 to 12. Substituent groups able to be present in the alkyl groups, alkenyl groups, alkynyl groups, aralkyl groups, alkoxy groups, alkoxyalkyl groups, alkylol groups, acetyl groups and aromatic groups mentioned above include hydroxyl groups; halogen atoms such as chlorine atoms; and cyano groups. Substituent groups able to be present in the alkyl groups, alkenyl groups, alkynyl groups, aralkyl groups, alkoxy groups, alkoxyalkyl groups, alkylol groups and acetyl groups mentioned above also include the aromatic groups mentioned above. Substituent groups able to be present in aromatic groups also include the alkyl groups, alkenyl groups, alkynyl groups, aralkyl groups, alkoxy groups, alkoxyalkyl groups, alkylol groups and acetyl groups mentioned above. Of these $R^2$ and $R^3$ are preferably alkyl groups having 1 to 18 carbon atoms (preferably 1 to 8 carbon atoms, for example 1 to 4 carbon atoms, and typically 1, 2 or 3 carbon atoms). These alkyl groups may be straight chain-like or branched. In addition, it is also preferable for $R^2$ and $R^3$ to be alkoxy groups, alkoxyalkyl groups, alkylol groups or acetyl groups. The alkoxy groups mentioned above are preferably alkoxy groups having 1 to 8 carbon atoms (for example, 1 to 6 carbon atoms, and typically 1 to 4 carbon atoms) (for example, methoxy groups). In addition, the alkoxyalkyl groups are preferably alkoxyalkyl groups having 1 to 8 carbon atoms (for example, 1 to 6 carbon atoms, and typically 1 to 4 carbon atoms) (for example, methoxymethyl groups, ethoxymethyl groups, propoxymethyl groups or butoxymethyl groups). The alkylol groups mentioned above are more preferably alkylol groups having 1 to 8 carbon atoms (for example, 1 to 6 carbon atoms, and typically 1, 2 or 3 carbon atoms) (for example, methylol groups, ethylol groups or propylol groups). $R^2$ and $R^3$ may be the same as, or different from, each other. In addition, $R^2$ and $R^3$ may bond to each other to form a cyclic structure. In cases where $R^2$ and $R^3$ bond to each other to form a cyclic structure, $-R^2R^3-$ can be $-(CH_2)_n-$. In such cases, n is preferably an integer of 3 to 10. The value of n is more preferably 4 to 6. The cyclic structure mentioned above may be a structure in which cyclic structures are linked via O or S. For example, $-R^2R^3-$ may be $-(CH_2)_m-O-(CH_2)_1-$ or $-(CH_2)_m-S-(CH_2)_1-$. Of these, $-(CH_2)_m-O-(CH_2)_1-$ is preferred. Here, m is an integer of 1 to 5. In addition, the value of m is preferably 1 to 3, and more preferably 2 or 3. 1 is an integer of 1 to 5. In addition, the value of 1 is preferably 1 to 3, and more preferably 2 or 3. At least one of the hydrogen atoms that constitute $R^2$ and $R^3$ may be substituted with an alkyl group, an alkenyl group, an alkynyl group, an aralkyl group, an alkoxy group, an alkoxyalkyl group, an alkylol group, an acetyl group, an aromatic group, or the like, and may also be substituted with a hydroxyl group, a halogen atom, an amino group, a cyano group, or the like.

In cases where X in the monomer a is an amidine group, that is, a group represented by $-C(=NR^4)-NR^5R^6$, $R^4$, $R^5$ and $R^6$ may be groups selected from among optionally substituted alkyl groups, alkenyl groups, alkynyl groups, aralkyl groups, alkoxy groups, alkoxyalkyl groups, alkylol groups and acetyl groups. The total number of carbon atoms in the optionally substituted alkyl groups, alkenyl groups, alkynyl groups, aralkyl groups, alkoxy groups, alkoxyalkyl groups, alkylol groups and acetyl groups is 1 to 40, preferably 1 to 24, more preferably 1 to 14, and further preferably 1 to 10. The total number of carbon atoms in the alkyl groups, alkenyl groups, alkynyl groups, aralkyl groups, alkoxy groups, alkoxyalkyl groups, alkylol groups and acetyl groups, excluding substituent groups, is 1 to 18, preferably 1 to 8, and more preferably 1 to 4. Of these $R^4$, $R^5$ and $R^6$ are preferably alkyl groups having 1 to 18 carbon atoms, preferably 1 to 8 carbon atoms, for example 1 to 4 carbon atoms, and typically 1, 2 or 3 carbon atoms. These alkyl groups may be straight chain-like or branched. In addition, it is also preferable for $R^4$, $R^5$ and $R^6$ to be alkoxy groups, alkoxyalkyl groups, alkylol groups or acetyl groups. $R^4$, $R^5$ and $R^6$ may be the same as, or different from, each other. In addition, $R^5$ and $R^6$ may bond to each other to form a cyclic structure.

In cases where X in the monomer a is a heterocyclic group that contains a nitrogen atom, the heterocyclic group that contains a nitrogen atom can be an aliphatic heterocyclic group or aromatic heterocyclic group not having a N-H bond. The aliphatic heterocyclic group and aromatic heterocyclic group may be monocyclic groups or fused ring groups. The total number of atoms that constitute the ring(s) in the aliphatic heterocyclic group and aromatic heterocyclic group is 3 to 15, preferably 3 to 12, more preferably 3 to 10, and further preferably 3 to 6. In addition to carbon atoms and nitrogen atoms, the aliphatic heterocyclic group and aromatic heterocyclic group may contain oxygen atoms and sulfur atoms as atoms that constitute the ring(s). In cases where the heterocyclic group that contains a nitrogen atom is an aliphatic heterocyclic group, examples thereof include piperidinyl groups, piperazinyl groups, piperazyl groups, pyrrolidinyl groups, imidazolidinyl groups, pyrazolidinyl groups, thiazolidinyl groups, isothiazolidinyl groups, oxazolidinyl groups, isooxazolidinyl groups, morpholinyl groups and pyrrolidone groups, and of these, pyrrolidone groups are preferred. In cases where the heterocyclic group that contains a nitrogen atom is an aromatic heterocyclic group, examples thereof include pyridyl groups, pyrazinyl groups, pyrimidinyl groups, pyridazinyl groups, triazinyl groups, pyrrolyl groups, imidazolyl groups, pyrazolyl groups, oxazolyl groups, isooxazolyl groups, thiazolyl groups, isothiazolyl groups, furazanyl groups and triazolyl groups, and of these, imidazolyl groups are preferred. It is preferable for a nitrogen atom that constitutes a ring in the heterocyclic groups mentioned above to be directly bonded to a carbon atom that constitutes a vinyl group ($CH_2=C-$). At least one of the hydrogen atoms that constitute the heterocyclic groups mentioned above may be substituted with an alkyl group, an alkenyl group, an alkynyl group, an aralkyl group, an alkoxy group, an alkoxyalkyl group, an alkylol group, an acetyl group, an aromatic group, or the like, and may also be substituted with a hydroxyl group, a halogen atom, an amino group, a cyano group, or the like.

A preferred example of the monomer a is a monomer in which $R^1$ is a hydrogen atom or a methyl group, X is an amide group represented by $-C(=O)-NR^2R^3$, and $R^2$ and $R^3$ bond to each other to form a cyclic structure. Specific examples of this type of monomer a1 include N-acryloylpiperidine, N-acryloylpiperidin-2-one, N-acryloylpiperazine, N-acryloylmorpholine, N-acryloyl-2-methylmorpholine, N-acryloyl-3-morpholinone, N-acryloyl-3,5-morpholine dione, N-acryloylthiomorpholine, N-acryloylpyrrolidine, N-acryloylpyrrolidone, N-acryloylaziridine, N-acryloylazetidine, N-acryloylazetidin-2-one, N-acryloylazepane, N-acryloylazocane, N-acryloylcaprolactam, N-methacryloylpiperidine, N-methacryloylpiperidin-2-one, N-methacryloylpiperazine, N-methacryloylmorpholine, N-methacryloyl-2-methylmorpholine, N-methacryloyl-3-morpholinone, N-methacryloyl-3,5-morpholine dione, N-methacryloylthiomorpholine, N-methacryloylpyrrolidine, N-methacryloylpyrrolidone, N-methacryloylaziridine, N-methacryloylazetidine, N-methacryloylazetidin-2-one, N-methacryloylazepane, N-methacryloylazocane and N-methacryloylcaprolactam. Of these, N-acryloylmorpholine is preferred.

Other examples of the monomer a may include monomers in which $R^1$ is a hydrogen atom or a methyl group, X is an amide group, that is, a group represented by $-C(=O)-NR^2R^3$, $R^2$ and $R^3$ are groups selected from among optionally substituted alkyl groups, alkenyl groups, alkynyl groups, aralkyl groups, alkoxy groups, alkoxyalkyl groups, alkylol groups, acetyl groups and aromatic groups. Specific examples of this type of monomer a2 include N,N-dialkylacrylamides such as N,N-dimethylacrylamide, N,N-diethylacrylamide, N,N-dipropylacrylamide, N,N-diisopropylacrylamide, N,N-dibutylacrylamide, N,N-diisobutylacrylamide, N,N-di-tert-butylacrylamide, N,N-diheptylacrylamide, N,N-dioctylacrylamide, N,N-di-tert-octylacrylamide, N,N-didodecylacrylamide and N,N-dioctadecylacrylamide; substituted N,N-dialkylacrylamides such as N,N-bis(2-hydroxyethyl)acrylamide and N,N-bis(2-cyanoethyl)acrylamide; N,N-dialkenylacrylamides such as N,N-diallylacrylamide; aromatic group-containing acrylamides such as N,N-diphenylacrylamide and N,N-dibenzylacrylamide; N,N-dialkylolacrylamides such as N,N-dimethylolacrylamide, N,N-diethylolacrylamide and N,N-dipropylolacrylamide; N-alkoxy-N-alkylacrylamides such as N-methyl-N-methoxyacrylamide, N-methyl-N-ethoxyacrylamide, N-methyl-N-propoxyacrylamide, N-methyl-N-butoxyacrylamide, N-ethyl-N-methoxyacrylamide, N-ethyl-N-ethoxyacrylamide, N-ethyl-N-butoxyacrylamide, N-propyl-N-methoxyacrylamide, N-propyl-N-ethoxyacrylamide, N-butyl-N-methoxyacrylamide and N-butyl-N-ethoxyacrylamide; N,N-diacetylacrylamide; N,N-diacetoneacrylamide; N,N-dialkylmethacrylamides such as N,N-dimethylmethacrylamide, N,N-diethylmethacrylamide, N,N-dipropylmethacrylamide, N,N-diisopropylmethacrylamide, N,N-dibutylmethacrylamide, N,N-diisobutylmethacrylamide, N,N-di-tert-butylmethacrylamide, N,N-diheptylmethacrylamide, N,N-dioctylmethacrylamide, N,N-di-tert-octylmethacrylamide, N,N-didodecylmethacrylamide and N,N-dioctadecylmethacrylamide; substituted N,N-dialkylmethacrylamides such as N,N-bis(2-hydroxyethyl)methacrylamide and N,N-bis(2-cyanoethyl)methacrylamide; N-dialkenylmethacrylamides such as N,N-diallylmethacrylamide; aromatic group-containing methacrylamides such as N,N-diphenylmethacrylamide and N,N-dibenzylmethacrylamide; N,N-dialkylolmethacrylamides such as N,N-dimethylolmethacrylamide, N,N-diethylolmethacrylamide and N,N-dipropylolmethacrylamide; N-alkoxy-N-alkylmethacrylamides such as N-methyl-N-methoxymethacrylamide, N-methyl-N-ethoxymethacrylamide, N-methyl-N-propoxymethacrylamide, N-methyl-N-butoxymethacrylamide, N-ethyl-N-methoxymethacrylamide, N-ethyl-N-ethoxymethacrylamide, N-ethyl-N-butoxymethacrylamide, N-propyl-N-methoxymethacrylamide, N-propyl-N-ethoxymethacrylamide, N-butyl-N-methoxymethacrylamide and N-butyl-N-ethoxymethacrylamide; N,N-diacetylmethacrylamide; and N,N-diacetonemethacrylamide.

Other preferred examples of the monomer a include monomers in which $R^1$ is a hydrogen atom or a methyl group and X is a heterocyclic group that contains a nitrogen atom. Specific examples of this type of monomer a3 include N-vinyl-2-pyrrolidone, N-vinylpyrazine, N-vinylimidazole, N-vinyloxazole, N-vinylmorpholine, N-vinylpyrazole, N-vinylisooxazole, N-vinylthiazole, N-vinylisothiazole, N-vinylpyridazine, N-vinylpyridine, N-vinylpyrimidine, N-vinylpiperazine, N-vinylpyrrole, N-methylvinylpyrrolidone, N-vinylpiperidone, N-vinyl-2-piperidone, N-vinyl-3-morpholinone, N-vinyl-2-caprolactam, N-vinyl-1,3-oxazin-2-one and N-vinyl-3,5-morpholine dione. Of these, N-vinyl-2-pyrrolidone and N-vinylimidazole are preferred. It is possible to use one of the polymerizable monomers a mentioned above in isolation, or a combination of two or more types.

The molecular weight of the nitrogen-containing water-soluble polymer mentioned above is not particularly limited. For example, the Mw of the nitrogen-containing water-soluble polymer is typically $1 \times 10^3$ or more, and is preferably $5 \times 10^3$ or more, more preferably $1 \times 10^4$ or more, and further preferably $1.5 \times 10^4$ or more, from perspectives such as reducing the amount of roll off. In addition, the Mw of the nitrogen-containing water-soluble polymer is typically $100 \times 10^4$ or less, preferably $90 \times 10^4$ or less, more preferably $75 \times 10^4$ or less, and further preferably $60 \times 10^4$ or less. In cases where the nitrogen-containing water-soluble polymer is a nitrogen-containing water-soluble polymer having, in the main chain, a constituent unit A derived from the monomer a1, the Mw thereof is preferably $5 \times 10^4$ or more, more preferably $10 \times 10^4$ or more, even more preferably $30 \times 10^4$ or more, and particularly preferably $50 \times 10^4$ or more, and is, for example, $70 \times 10^4$ or less, from perspectives such as reducing the amount of roll off. In cases where the nitrogen-containing water-soluble polymer is a nitrogen-containing water-soluble polymer having, in the main chain, a constituent unit A derived from the monomer a3, the Mw thereof is preferably $0.5 \times 10^4$ or more, more preferably $1 \times 10^4$ or more, and further preferably $1.5 \times 10^4$ or more, and is, for example $30 \times 10^4$ or less, from perspectives such as reducing the amount of roll off. Moreover, as the Mw of the nitrogen-containing water-soluble polymer, a value obtained using gel permeation chromatography (GPC) can be used.

The nitrogen-containing water-soluble polymer disclosed here preferably comprises substantially only constituent unit A. In other words, in the nitrogen-containing water-soluble polymer, the proportion (molar ratio) of the number of moles of constituent unit A relative to the number of moles of all constituent units contained in the molecular structure of the polymer is preferably 99 mol% or more. This molar ratio can be, for example, 99.9 mol% or more, and typically 99.9 to 100 mol%. Preferred examples of this type of polymer include homopolymers comprising only one type of polymerizable monomer a disclosed here and copolymers comprising two or more types of polymerizable monomer a.

In addition, the nitrogen-containing water-soluble polymer disclosed here may be a copolymer that includes constituent units derived from one or two or more types of monomer b able to be copolymerized with the polymerizable monomer a (hereinafter referred to as "constituent unit B") as long as the advantageous effect of the invention is not significantly impaired. This constituent unit B is defined as being different from constituent unit A. Constituent unit B can be a constituent unit that does not contain a nitrogen atom. The proportion (molar ratio) of constituent unit B in the nitrogen-containing water-soluble polymer can be less than 50 mol%. This molar ratio can be, for example, less than 30 mol%, and typically less than 10 mol%.

Moreover, the term "mol%" mentioned above is the molar ratio calculated on the understanding that one molecule is one constituent unit derived from one monomer. Here, the "one monomer" encompasses both the polymerizable monomer a and the monomer b. Therefore, the proportions of constituent units A and B can correspond to the molar ratios of the polymerizable monomer a and the monomer b relative to the overall monomer component used in the polymerization.

<Water>

The polishing composition disclosed here typically contains water in addition to the nitrogen-containing water-soluble polymer mentioned above. Ion exchanged water (deionized water), pure water, ultrapure water, distilled water, and the like, can be advantageously used as the water. In order for the functions of other components contained in the polishing composition to be impaired as little as possible, the water used preferably has a total content of, for example, transition metal ions of 100 ppb or less. For example, it is possible to increase the purity of the water by removing impurity ions by means of an ion exchange resin, removing contaminants by means of filtration, or carrying out a procedure such as distillation.

The polishing composition disclosed here may, if necessary, further contain an organic solvent able to be homogeneously mixed with water. Examples of the organic solvent include lower alcohols and lower ketones. In general, it is preferable for not less than 90 vol%, and more preferably not less than 95 vol%, of the solvent contained in the polishing composition to be water. Typically, water accounts for 99 to 100 vol% of the solvent contained in the polishing composition.

<Abrasive>

The polishing composition disclosed here contains abrasive in addition to the nitrogen-containing water-soluble polymer and water. In the art disclosed here, the material and form of the abrasive are not particularly limited, and should be selected, as appropriate, in view of the intended use or mode of use of the polishing composition. Examples of abrasive include inorganic particles, organic particles and organic-inorganic composite particles. Specific examples of inorganic particles include oxide particles such as silica particles, alumina particles, cerium oxide particles, chromium oxide particles, titanium dioxide particles, zirconium oxide particles, magnesium oxide particles, manganese dioxide particles, zinc oxide particles and red iron oxide particles; nitride particles such as silicon nitride particles and boron nitride particles; carbide particles such as silicon carbide particles and boron carbide particles; diamond particles; and carbonates such as calcium carbonate and barium carbonate. Specific examples of organic particles include poly(methyl methacrylate) (PMMA) particles, poly((meth)acrylic acid) particles and polyacrylonitrile particles. Here, (meth)acrylic acid encompasses both acrylic acid and methacrylic acid. It is possible to use one of these types of abrasive in isolation or a combination of two or more types.

The abrasive is preferably inorganic particles, and of these, particles comprising metal or metalloid oxides are preferred. Preferred examples of abrasive able to be used in the art disclosed here include silica particles. For example, in cases where the art disclosed here is used in a polishing composition able to be used for polishing silicon wafers, use of silica particles as the abrasive is particularly preferred. The reason for this is as follows. In cases where a polishing object is a silicon wafer, if silica particles, which comprise oxygen atoms and an element that is the same as the polishing object, are used as the abrasive, residues of metals and metalloids other than silicon do not occur after polishing. As a result, there are no concerns regarding a deterioration in the electrical characteristics of a silicon wafer caused by metals and metalloids other than silicon contaminating the surface of the silicon wafer or diffusing into the inner part of the polishing object. Furthermore, because silicon and silica are similar in terms of hardness, it is possible to carry out a polishing procedure without causing excessive damage to the surface of a silicon wafer. From these perspectives, a preferred form of the polishing composition is a polishing composition that contains only silica particles as abrasive. Specific examples of silica particles include colloidal silica, fumed silica and precipitated silica. From perspectives such as preventing scratches on the surface of a polishing object and being able to achieve a surface having a lower haze value, colloidal silica and fumed silica can be given as preferred examples of silica particles. Of these, colloidal silica is preferred. For example, colloidal silica can be advantageously used as abrasive in a polishing composition used for polishing silicon wafers. Here, polishing means at least one of stock polishing and final polishing, and preferably means stock polishing.

In the art disclosed here, abrasive contained in the polishing composition may be in the form of primary particles or in the form of secondary particles formed by aggregation of a plurality of primary particles. In addition, it is possible for a mixture of abrasive in the form of primary particles and abrasive in the form of secondary particles to be present. In a preferred embodiment, the polishing composition contains at least some of the abrasive in the form of secondary particles.

The average primary particle diameter $D_{P1}$ of the abrasive is not particularly limited, but is preferably 5 nm or more, more preferably 10 nm or more, and particularly preferably 20 nm or more, from perspectives such as polishing removal rate. From perspectives such as a higher polishing effect, the average primary particle diameter $D_{P1}$ is preferably 25 nm or more, and further preferably 30 nm or more. Abrasive having an average primary particle diameter $D_{P1}$ of 40 nm or more may be used. In addition, the average primary particle diameter of the abrasive is preferably 200 nm or less, and more preferably 150 nm or less, for example 100 nm or less, from perspectives such as storage stability. Here, an example of storage stability is dispersion stability.

Moreover, in the art disclosed here, the average primary particle diameter $D_{P1}$ of the abrasive can be calculated from, for example, the specific surface area (BET value), as measured using the BET method, using the formula $D_{P1}$ [nm] = 6000/(true density [g/cm$^3$] × BET value [m$^2$/g]). For example, in the case of silica particles, the average primary particle diameter can be calculated using the formula $D_{P1}$ [nm] = 2727/BET value [nm]. Specific surface area can be measured using, for example, a "Flow Sorb II 2300" surface area measurement apparatus available from Micromeritics Instrument Corporation.

The average secondary particle diameter $D_{P2}$ of the abrasive is not particularly limited, but is preferably 15 nm or more, and more preferably 30 nm or more, from perspectives such as polishing removal rate. From perspectives such as a higher polishing effect, the average secondary particle diameter $D_{P2}$ is preferably 50 nm or more. In addition, the average secondary particle diameter $D_{P2}$ of the abrasive should be 300 nm or less, and is preferably 260 nm or less, more preferably 220 nm or less, from perspectives such as storage stability. Here, an example of storage stability is dispersion stability. The average secondary particle diameter $D_{P2}$ of the abrasive can be measured by, for example, a dynamic light scattering method using a "UPA-UT151" apparatus available from Nikkiso Co., Ltd.

The shape (outer shape) of the abrasive may be globular or non-globular. Specific examples of non-globular abrasive include particles of a peanut shape (i.e., in the form of a shell of a peanut), a cocoon shape, a konpeito shape or a rugby ball shape.

The shape (outer shape) of the abrasive can be grasped from, for example, electron microscope observations.

<Basic compound>

The polishing composition disclosed here contains a basic compound. Here, the term "basic compound" means a compound having the function of increasing the pH of the polishing composition when added to the composition. The basic compound may be an organic basic compound or an inorganic basic compound. It is possible to use one of these basic compounds in isolation or a combination of two or more types.

Examples of organic basic compounds include quaternary ammonium salts such as tetraalkylammonium salts. Anions in such ammonium salts can be, for example, OH$^-$, F$^-$, Cl$^-$, Br$^-$, I$^-$, ClO$_4$$^-$, BH$_4$$^-$, or the like. For example, quaternary ammonium salts such as choline, tetramethylammonium hydroxide, tetraethylammonium hydroxide, tetrapropylammonium hydroxide and tetrabutylammonium hydroxide can be advantageously used. Of these, tetramethylammonium hydroxide is preferred.

Other examples of organic basic compounds include quaternary phosphonium salts such as tetraalkylphosphonium salts. Anions in such phosphonium salts can be, for example, OH$^-$, F$^-$, Cl$^-$, Br$^-$, I$^-$, ClO$_4$$^-$, BH$_4$$^-$, or the like. For example, tetramethylphosphonium, tetraethylphosphonium, tetrapropylphosphonium and tetrabutylphosphonium halides and hydroxides can be advantageously used.

Other examples of organic basic compounds include amines such as methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine and triethylenetetramine; piperazine compounds such as 1-(2-aminoethyl)piperazine and N-methylpiperazine; azole compounds such as imidazole and triazole; and guanidine.

Examples of inorganic basic compounds include ammonia; hydroxides of ammonia, alkali metals and alkaline earth metals; carbonates of ammonia, alkali metals and alkaline earth metals; and bicarbonates of ammonia, alkali metals and alkaline earth metals. Specific examples of such hydroxides include potassium hydroxide and sodium hydroxide. Specific examples of such carbonates and bicarbonates include ammonium bicarbonate, ammonium carbonate, potassium bicarbonate, potassium carbonate, sodium bicarbonate and sodium carbonate.

Arbitrary preferred basic compounds include ammonia, potassium hydroxide, sodium hydroxide, tetramethylammonium hydroxide, tetraethylammonium hydroxide, ammonium bicarbonate, ammonium carbonate, potassium bicarbonate, potassium carbonate, sodium bicarbonate and sodium carbonate. Of these, ammonia, potassium hydroxide, sodium hydroxide, tetramethylammonium hydroxide and potassium carbonate are preferred. Of these, tetramethylammonium hydroxide and potassium carbonate are more preferred.

<Other components>

The polishing composition disclosed here may, if necessary, further contain publicly known additives able to be used in polishing compositions, such as chelating agents, other water-soluble polymers, surfactants, organic acids, organic acid salts, inorganic acids, inorganic acid salts, antiseptic agents and anti-fungal agents, as long as the advantageous effect of the present invention is not significantly impaired. This polishing composition is typically a polishing composition able to be used in a silicon wafer polishing step.

Chelating agents form complex ions with metal impurities that may be present in the polishing composition, and trap these metal impurities. As a result, chelating agents have the function of suppressing contamination of a polishing object by metal impurities. It is possible to use one of these chelating agents in isolation or a combination of two or more types.

Examples of chelating agents include aminocarboxylic acid-based chelating agents, organic phosphonic acid-based chelating agents and organic sulfonic acid-based chelating agents. Examples of aminocarboxylic acid-based chelating agents include ethylenediamine tetraacetic acid, sodium ethylenediamine tetraacetate, nitrilotriacetic acid, sodium nitrilotriacetate, ammonium nitrilotriacetate, hydroxyethylethylenediamine triacetic acid, sodium hydroxyethylethylenediamine triacetate, diethylenetriamine pentaacetic acid, sodium diethylenetriamine pentaacetate, triethylenetetramine hexaacetic acid and sodium triethylenetetramine hexaacetate. Examples of organic phosphonic acid-based chelating agents include 2-aminoethylphosphonic acid, 1-hydroxyethylidene-1,1-diphosphonic acid, aminotri(methylenephosphonic acid), ethylenediaminetetrakis(methylenephosphonic acid), diethylenetriamine-penta(methylenephosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxy-1,2-diphosphonic acid, methanehydroxyphosphonic acid, 2-phosphonobutane-1,2-dicarboxylic acid, 1-phosphonobutane-2,3,4-tricarboxylic acid and $\alpha$-methylphosphono-succinic acid. Examples of organic sulfonic acid-based chelating agents include ethylenediaminetetrakis(methylenesulfonic acid). Of these, organic phosphonic acid-based chelating agents and organic sulfonic acid-based chelating agents are more preferred, and of these, ethylenediaminetetrakis(methylenephosphonic acid) is preferred.

Examples of other water-soluble polymers include cellulose derivatives, starch derivatives, polymers containing oxyalkylene units and vinyl alcohol-based polymers. Specific examples include hydroxyethyl cellulose, pullulan, random copolymers and block copolymers of ethylene oxide and propylene oxide, poly(vinyl alcohol), polyisoprene sulfonic acid, poly(vinylsulfonic acid), poly(allylsulfonic acid), poly(isoamylenesulfonic acid), polystyrene sulfonic acid salts, poly(acrylic acid) salts, poly(vinyl acetate) and polyethylene glycol. It is possible to use one of these water-soluble polymers in isolation or a combination of two or more types thereof. The polishing composition disclosed here may be a composition that contains substantially no other water-soluble polymer.

The polishing composition can contain a surfactant as an optional component. Surfactants can contribute to an improvement in dispersion stability of a polishing slurry or concentrate thereof. Anionic surfactants and non-ionic surfactants can be advantageously used. From the perspectives of low foaming properties and ease of pH adjustment, non-ionic surfactants are more preferred. Examples thereof include non-ionic surfactants such as oxyalkylene polymers, such as polyethylene glycol, polypropylene glycol and polytetramethylene glycol; polyoxyalkylene adducts such as polyoxyethylene alkyl ethers, polyoxyethylene alkyl phenyl ethers, polyoxyethylene alkylamines, polyoxyethylene fatty acid esters, polyoxyethylene glyceryl ether fatty acid esters and polyoxyethylene sorbitan fatty acid esters; and copolymers of multiple oxyalkylene compounds (for example, diblock copolymers, triblock copolymers, random copolymers and alternating copolymers). Of these, polyoxyethylene alkyl ethers are more preferred. It is possible to use one of these surfactants in isolation or a combination of two or more types.

The Mw of the surfactant is typically less than $1 \times 10^4$, and is preferably 9500 or less from perspectives such as filtration properties of the polishing composition and cleaning properties of a polishing object. In addition, the Mw of the surfactant is typically 200 or more, preferably 250 or more, and more preferably 300 or more (for example, 500 or more). As the Mw of the surfactant, a value calculated from the chemical formula thereof can be used.

Examples of organic acids include fatty acids such as formic acid, acetic acid and propionic acid; aromatic carboxylic acids such as benzoic acid and phthalic acid; citric acid; oxalic acid; tartaric acid; malic acid; maleic acid; fumaric acid; succinic acid; organic sulfonic acids; and organic phosphonic acids. Examples of organic acid salts include alkali metal salts and ammonium salts of organic acids. Here, examples of alkali metal salts include sodium salts and potassium salts. Examples of inorganic acids include sulfuric acid, nitric acid, hydrochloric acid and carbonic acid. Examples of inorganic acid salts include alkali metal salts and ammonium salts of inorganic acids. Here, examples of alkali metal salts include sodium salts and potassium salts. It is possible to use one of these organic acids and salts thereof and inorganic acids and salts thereof in isolation, or a combination of two or more types thereof.

Examples of antiseptic agents and anti-fungal agents include isothiazoline-based compounds, parahydroxybenzoic acid esters and phenoxyethanol.

The polishing composition disclosed here preferably contains substantially no oxidant. If the polishing composition contains an oxidant, when the composition is supplied to a polishing object, the surface of the polishing object is oxidized and an oxide film is produced. Here, the polishing object is, for example, a silicon wafer. As a result, the time required for polishing increases. Here, examples of oxidants include hydrogen peroxide ($H_2O_2$), sodium persulfate, ammonium persulfate and sodium dichloroisocyanurate. Moreover, "the polishing composition contains substantially no oxidant" means at least that an oxidant is not intentionally incorporated in the composition. Therefore, a polishing composition in which a small quantity of an oxidant derived from raw materials or the production method is unavoidably contained is encompassed by the concept of a polishing composition that contains substantially no oxidant mentioned here. Here, the term "small quantity" means that the molar concentration of an oxidant in the polishing composition is, for example, 0.0005 mol/L or less, preferably 0.0001 mol/L or less, more preferably 0.00001 mol/L or less, and particularly preferably 0.000001 mol/L or less.

<Preparation of polishing composition>

The method for producing the polishing composition disclosed here is not particularly limited. For example, the components contained in the polishing composition should be mixed using, for example, a well-known mixing apparatus such as a blade type stirrer, an ultrasonic disperser or a homomixer. The manner in which these components are mixed is not particularly limited. For example it is possible to mix all of the components at once or mix the components in an appropriately specified order.

The polishing composition disclosed here may be a one-agent type or a multi-agent type such as a two-agent type. For example, it is possible for a part A, which contains some of the constituent components of the polishing composition, and a part B, which contains the remaining components of the composition, to be mixed and used for polishing a polishing object. Typically, part A can be components other than an aqueous medium.

<Polishing slurry>

The polishing composition disclosed here is typically supplied to a polishing object in the form of a polishing slurry that contains the polishing composition. In addition, the polishing composition is used in the form of a polishing slurry to polish a polishing object. The polishing slurry can be prepared by diluting any of the polishing compositions disclosed here. Here, dilution is typically dilution with water. Alternatively, the polishing composition may be used as-is as a polishing slurry. That is, the scope of the polishing composition in the art disclosed here encompasses both a polishing slurry (a working slurry) that is supplied to a polishing object and used to polish the polishing object, and a concentrate (a polishing slurry stock solution) that is diluted and then used as a polishing slurry. Other examples of polishing slurry that contain the polishing composition disclosed here include polishing slurry obtained by adjusting the pH of the composition.

The content of the nitrogen-containing water-soluble polymer in the polishing slurry disclosed here is not particularly limited, but a content of 0.00001 wt% or more is generally suitable. From perspectives such as reducing the amount of roll off, this content is preferably 0.00005 wt% or more, more preferably 0.0001 wt% or more, and further preferably 0.0003 wt% or more. In addition, from the perspective of achieving a high degree of balance between polishing removal rate and reduced edge roll off, a nitrogen-containing water-soluble polymer content of 0.01 wt% or less is generally suitable, and this content is preferably 0.008 wt% or less, and more preferably 0.005 wt% or less. For example, this content is preferably 0.003 wt% or less or 0.002 wt% or less. The art disclosed here can be advantageously carried out by an embodiment in which the content of the nitrogen-containing water-soluble polymer is 0.0005 to 0.001 wt%.

The content of the abrasive in the polishing slurry disclosed here is not particularly limited, but is typically 0.01 wt% or more, preferably 0.03 wt% or more, more preferably 0.05 wt% or more, and further preferably 0.1 wt% or more. A higher polishing removal rate can be achieved by increasing the content of the abrasive. In addition, from perspectives such as dispersion stability of the polishing composition, an abrasive content of 10 wt% or less is generally suitable, and this content is preferably 5 wt% or less, more preferably 3 wt% or less, and further preferably 1 wt% or less, for example 0.8 wt% or less.

A content of 0.001 wt% or more is generally suitable as the content of the basic compound in the polishing slurry disclosed here. From perspectives such as reducing the amount of roll off, this content is preferably 0.005 wt% or more, more preferably 0.01 wt% or more, and further preferably 0.03 wt% or more. In addition, from the perspective of achieving a high degree of balance between polishing removal rate and reduced edge roll off, a basic compound content of 1 wt% or less is generally suitable, and this content is preferably 0.5 wt% or less, and more preferably 0.3 wt% or less. For example, this content is preferably 0.2 wt% or less.

In cases where the polishing slurry disclosed here contains a chelating agent, the chelating agent content in the polishing slurry is suitably 0.0001 wt% or more in general. This content is preferably 0.0005 wt% or more, more preferably 0.001 wt% or more, further preferably 0.0015 wt% or more, and particularly preferably 0.002 wt% or more. In addition, a chelating agent content of 0.05 wt% or less is generally suitable, and this content is preferably 0.01 wt% or less, more preferably 0.008 wt% or less, and further preferably 0.005 wt% or less.

The pH of the polishing slurry is 8.0 or more, and is, for example, preferably 8.5 or more, more preferably 9.0 or more, further preferably 9.5 or more, and particularly preferably 10.0 or more, for example 10.5 or more. If the pH of the polishing slurry increases, the polishing removal rate tends to improve. The upper limit for the pH of the polishing slurry is not particularly limited, but is 12.0 or less, and is, for example, preferably 11.8 or less, and more preferably 11.5 or less. As a result, a polishing object can be better polished. This pH can be advantageously used for a polishing slurry used for polishing a silicon wafer.

<Concentrate>

The polishing composition disclosed here may be in a concentrated form before being supplied to a polishing object (i.e., in the form of a polishing slurry concentrate). A polishing composition that has been concentrated in this way is advantageous from perspectives such as convenience and reduced costs during manufacture, distribution and storage. The concentration factor can be, for example, approximately 2- to 60-fold by volume.

The polishing composition in this type of concentrated form as this can be used in an embodiment in which the composition is diluted when needed to prepare a polishing slurry and the polishing slurry is then supplied to a polishing object. Typically, this dilution can be carried out by adding an aqueous medium mentioned above to the concentrate and mixing. In addition, in cases where the aqueous medium is a mixed solvent, it is possible to dilute by adding only some of the constituent components of the aqueous medium or by adding a mixed solvent containing these constituent components at quantity ratios different from that of the aqueous medium. In addition, in a multi-component polishing composition, such as that described below, it is possible to prepare a polishing slurry by diluting some of these components and then mixing with the remaining components, or by mixing the multiple components and then diluting this mixture.

The content of the abrasive in the concentrate can be, for example, 50 wt% or less. From perspectives such as stability and filtration properties of the polishing composition, the content of the abrasive is preferably 45 wt% or less, and more preferably 40 wt% or less. Here, an example of polishing composition stability is dispersion stability of the abrasive. In addition, from perspectives such as convenience and reduced costs during manufacture, distribution and storage, the content of the abrasive can be, for example, 1.0 wt% or more, and is preferably 3.0 wt% or more, more preferably 5.0 wt% or more, and further preferably 7.0 wt% or more.

The content of the nitrogen-containing water-soluble polymer in the concentrate is not particularly limited, but a content of 0.0003 wt% or more is generally suitable. This content is preferably 0.0015 wt% or more, more preferably 0.003 wt% or more, further preferably 0.01 wt% or more, and particularly preferably 0.02 wt% or more. In addition, a nitrogen-containing water-soluble polymer content of 0.3 wt% or less is generally suitable, and this content is preferably 0.15 wt% or less, more preferably 0.1 wt% or less, and further preferably 0.05 wt% or less.

A content of 0.03 wt% or more is generally suitable as the content of the basic compound in the concentrate. This content is preferably 0.15 wt% or more, more preferably 0.3 wt% or more, and further preferably 1 wt% or more. In addition, a basic compound content of 15 wt% or less is generally suitable, and this content is preferably 10 wt% or less, and more preferably 6 wt% or less.

In cases where the concentrate disclosed here contains a chelating agent, a chelating agent content of 0.003 wt% or more in the polishing slurry is generally suitable. This content is preferably 0.005 wt% or more, more preferably 0.01 wt% or more, further preferably 0.03 wt% or more, and particularly preferably 0.05 wt% or more. In addition, a chelating agent content of 1.5 wt% or less is generally suitable, and this content is preferably 1 wt% or less, more preferably 0.5 wt% or less, further preferably 0.3 wt% or less, and particularly preferably 0.1 wt% or less.

The polishing composition in this type of concentrated form as this can be used in an embodiment in which the composition is diluted when needed to prepare a polishing slurry and the polishing slurry is then supplied to a polishing object. Typically, this dilution can be carried out by adding an aqueous medium mentioned above to the concentrate and mixing. In addition, in cases where the aqueous medium is a mixed solvent, it is possible to dilute by adding only some of the constituent components of the aqueous medium or by adding a mixed solvent containing these constituent components at quantity ratios different from that of the aqueous medium. In addition, in a multi-component polishing composition, such as that described below, it is possible to prepare a polishing slurry by diluting some of these components and then mixing with the remaining components, or by mixing the multiple components and then diluting this mixture.

<Applications>

The polishing composition disclosed here can be used to polish polishing objects comprising a variety of materials and shapes. Materials of polishing objects can be, for example, metals or metalloids such as silicon, aluminum, nickel, tungsten, copper, tantalum, titanium, stainless steel and germanium, or alloys thereof; glassy substances such as quartz glass, aluminosilicate glass and glassy carbon; ceramic materials such as alumina, silica, sapphire, silicon nitride, tantalum nitride and titanium carbide; compound semiconductor substrate materials such as silicon carbide, gallium nitride and gallium arsenide; and resin materials such as polyimide resins. A polishing object may be constituted from a plurality of these materials. Of these, the polishing composition is suitable for polishing a polishing object having a surface comprising silicon. The art disclosed here is, for example, a polishing composition that contains silica particles as abrasive, and can be used particularly advantageously as a polishing composition for which a polishing object is silicon. Typically, the polishing composition contains only silica particles as abrasive.

The shape of the polishing object is not particularly limited. The polishing composition disclosed here can be advantageously used to polish, for example, a polishing object having a flat surface, such as a sheet or polyhedron, or edges of a polishing object. For example, the polishing composition can be advantageously used to polish wafer edges.

<Polishing method>

The polishing composition disclosed here can be advantageously used as a polishing composition for polishing silicon. For example, the polishing composition can be advantageously used as a polishing composition for polishing a monocrystalline or polycrystalline silicon wafer. An explanation will now be given of a preferred embodiment of a method for polishing a polishing object using the polishing composition disclosed here.

That is, a polishing liquid (slurry) containing any of the polishing compositions disclosed here is prepared. The preparation of the polishing slurry can comprise adding an operation such as adjusting the concentration of the polishing composition. Here, an example of concentration adjustment is dilution. Alternatively, the polishing composition may be used as-is as a polishing slurry. In addition, in the case of a multi-component polishing composition, the preparation of the polishing slurry can comprise mixing these components, diluting one or more of the components prior to mixing, or mixing and then diluting the obtained mixture.

Next, this polishing slurry is supplied to a polishing object and polishing is carried out using an ordinary method. For example, in cases where a polishing object is subjected to a primary polishing step, the polishing object is subjected to a lapping step and then placed in an ordinary polishing machine. In the primary polishing step, it is typical for both surfaces of the polishing object to be polished. The polishing slurry is supplied to a surface of the polishing object (a surface to be polished) via a polishing pad in the polishing machine. Typically, while the polishing slurry is continuously supplied, the polishing pad is pushed against the surface of the polishing object, and the two are moved against each other (for example, moved in circular motion). Polishing of the polishing object is then completed by carrying out a final polishing, after an optional secondary polishing step. In the secondary polishing step, it is typical for one surface of the polishing object to be polished.

Moreover, the polishing pad used in the polishing step in which the polishing composition disclosed here is used is not particularly limited. For example, it is possible to use a non-woven fabric polishing pad, a suede type polishing pad, a polyurethane type polishing pad, a polishing pad that contains abrasive, a polishing pad that does not contain abrasive, or the like.

The present invention also provides a method for producing a polished article, the method including a step for polishing a polishing object using the polishing composition disclosed here. The method for producing a polished article disclosed here may also include a step for subjecting a polishing object, which has been polished using the polishing composition, to final polishing. Here, the term "final polishing" means a final polishing step in the process for producing the target product, that is, a step after which no further polishing is carried out. This final polishing step may be carried out using the polishing composition disclosed here or using another polishing composition.

In a preferred embodiment, a polishing step in which the polishing composition is used is a polishing step that is carried out prior to final polishing. Of these, the polishing composition can be advantageously used in stock polishing following completion of a lapping step. For example, the polishing composition can be advantageously used in a step in which both surfaces of a polishing object are polished after a lapping step (typically a primary polishing step) or in an initial step in which one surface of a substrate, which has been subjected to the step in which both surfaces are polished, is polished (typically an initial secondary polishing step). In the above-mentioned step in which both surfaces are polished and the above-mentioned initial step in which one surface is polished, the required polishing removal rate is greater than in the final polishing. Therefore, the polishing composition disclosed here is suitable for use as a polishing composition used for polishing a polishing object in at least one of the steps of a step in which both surfaces of the polishing object are polished and an initial step in which one surface of the polishing object is polished (and preferably both of these steps).

Moreover, the polishing composition may be used in a way such that the composition is used for polishing and then disposed (so-called "one-way"), but may also be used in recycle. One example of a method where the polishing composition is used in recycle is a method where a tank collects a used portion of the polishing composition released from a polishing machine and supplies the collected polishing composition back to the polishing machine. In cases where the polishing composition is used in recycle, it is possible to reduce the burden on the environment by reducing the amount of spent polishing composition treated as waste liquid compared to cases in which the polishing composition is used in one-way. In addition, it is possible to reduce costs by reducing the amount of polishing composition used. In cases where the polishing composition disclosed here is used in recycle, it is possible to add fresh components or components that have been depleted through use to the polishing composition during use at an appropriate time.

Several examples relating to the present invention will now be explained, but the present invention is in no way limited to these examples. Moreover, in the following explanations, "parts" and "%" are on a weight basis, unless otherwise indicated.

<Preparation of polishing composition>

(Example 1)

A polishing composition was prepared by mixing an abrasive, a nitrogen-containing water-soluble polymer, a basic compound, a chelating agent and deionized water. Silica particles (having an average primary particle diameter of 50 nm) were used as the abrasive. Polyacryloylmorpholine (hereinafter referred to as "PACMO") having a Mw of 55 $\times$ 10$^4$ was used as the nitrogen-containing water-soluble polymer. Tetramethylammonium hydroxide (hereinafter abbreviated to "TMAH"), imidazole (hereinafter abbreviated to "imd") and potassium carbonate (hereinafter abbreviated to "K$_2$CO$_3$") were used as basic compounds. Ethylenediaminetetrakis(methylenephosphonic acid) (hereinafter abbreviated to "EDTPO") was used as the chelating agent. In the polishing composition, the content of the abrasive was 15%, the content of the PACMO was 0.024%, the content of the TMAH was 2.1%, the content of the imd was 0.24%, the content of the K$_2$CO$_3$ was 1.4%, and the content of the EDTPO was 0.08%.

(Example 2)

Polyvinylimidazole (hereinafter abbreviated to "PVI") having a Mw of 1.7 $\times$ 10$^4$ was used instead of the PACMO. The content of the PVI in the polishing composition was 0.024%. Other than this, the polishing composition of the present example was prepared in the same way as in Example 1.

(Example 3)

Polyvinylpyrrolidone (hereinafter abbreviated to "PVP") having a Mw of 25 $\times$ 10$^4$ was used instead of the PACMO. The content of the PVP in the polishing composition was 0.024%. Other than this, the polishing composition of the present example was prepared in the same way as in Example 1.

(Comparative Example 1)

Poly(N-isopropylacrylamide) (hereinafter abbreviated to "PNIPAM") having a Mw of 6 $\times$ 10$^4$ was used instead of the PACMO. The content of the PNIPAM in the polishing composition was 0.024%. Other than this, the polishing composition of the present example was prepared in the same way as in Example 1.

(Comparative Example 2)

Poly(N-vinylacetamide) (hereinafter abbreviated to "PNVA") having a Mw of 1 $\times$ 10$^4$ was used instead of the PACMO. The content of the PNVA in the polishing composition was 0.024%. Other than this, the polishing composition of the present example was prepared in the same way as in Example 1.

(Comparative Example 3)

Polyhydroxyethylacrylamide (hereinafter abbreviated to "PHEAA") having a Mw of 29 $\times$ 10$^4$ was used instead of the PACMO. The content of the PHEAA in the polishing composition was 0.024%. Other than this, the polishing composition of the present example was prepared in the same way as in Example 1.

(Comparative Example 4)

The polishing composition of the present example was prepared in the same way as in Example 1, except that PACMO was not used.

For the polishing compositions of these examples, the type of nitrogen-containing water-soluble polymer used, the presence or absence of N-H bonds, the proportion of an amide structure relative to the overall mass of constituent unit A, and the Mw are collectively shown in Table 1.

<Evaluation of polishing removal rate of silicon >

Polishing slurry obtained by diluting the polishing compositions of the examples by 30 times with water were used, polishing tests were carried out using silicon wafers, and the silicon polishing removal rate and amount of edge roll off were evaluated. A silicon wafer measuring 6 cm × 6 cm (p-type conductivity, crystal orientation of <100>) was used as a test piece. This test piece was polished under the following conditions. In addition, the polishing removal rate was calculated using calculation formulae (a) and (b) below. The results are shown in the corresponding column in Table 1.

(a)

$$\text{Polishing removal [cm]} = \text{difference in weight [g] of silicon wafer before and after}$$

$$\text{polishing/density of silicon [g/cm}^3\text{] (= 2.33 g/cm}^3\text{)/area polished [cm}^2\text{] (= 36 cm}^2\text{)}$$

(b)

$$\text{Polishing removal rate [μm/min]} = \text{polishing removal [μm]/polishing time [min]}$$

[Polishing conditions]

Polishing machine: "EJ-380IN" table top polisher available from Engis Japan Corporation
Polishing pad: "MH S-15A" available from Nitta Haas Incorporated
Polishing pressure: 27 kPa
Platen rotational speed: 50 rpm
Head rotational speed: 40 rpm
Polishing removal: 8 μm
Flow rate of polishing slurry: 100 mL/min (showering use)
Polishing slurry temperature: 25°C

<Evaluation of amount of edge roll off>

The amount of edge roll off at the outer peripheral part of a silicon wafer was evaluated after polishing. The amount of edge roll off was evaluated by measuring a shape displacement amount of the surface of the silicon wafer using a "NewView 5032" available from Zygo Corporation (USA). Specifically, a comparatively flat region at a position of 2.0 to 4.0 mm from the outer peripheral edge of the silicon wafer towards the center of the wafer was used as a reference region, and a straight line (reference straight line) that approximates the shape displacement amount in this region was drawn using the least-squares method. Next, the maximum displacement in the shape of the silicon wafer at a position 2.0 mm from the outer peripheral edge was measured using a point on this reference straight line as a base point, and this was taken to be the amount of roll off of the silicon wafer. Moreover, if the outer peripheral edge of the silicon wafer is a roll off shape, the amount of roll off is negative, but if the outer peripheral edge of the silicon wafer is a roll up shape, the amount of roll off is positive. The obtained results are shown in the "Amount of roll off (nm)" column in Table 1.

[Table 1]

Table 1

| | Polymer | N-H bond presence/ absence | Proprtion [%] of amide structure | Mw | Amount of roll off [nm] | Polishing removal rate [μm/min] |
|---|---|---|---|---|---|---|
| Example 1 | PACMO | Absence | 29.8 | 550000 | -52.5 | 0.31 |
| Example 2 | PVI | Absence | 0.0 | 17000 | -88.3 | 0.33 |
| Example 3 | PVP | Absence | 37.8 | 250000 | -90.0 | 0.31 |

(continued)

|  | Polymer | N-H bond presence/ absence | Proprtion [%] of amide structure | Mw | Amount of roll off [nm] | Polishing removal rate [μm/min] |
|---|---|---|---|---|---|---|
| Comparative Example 1 | PNIPAM | Presence | 37.2 | 60000 | -112.1 | 0.32 |
| Comparative Example 2 | PNVA | Presence | 49.4 | 10000 | -319.5 | 0.30 |
| Comparative Example 3 | PHEAA | Presence | 36.5 | 290000 | -365.3 | 0.32 |
| Comparative Example 4 | - | - | - | - | -407.3 | 0.34 |

As shown in Table 1, the polishing compositions of Examples 1 to 3, in which nitrogen-containing water-soluble polymers not having a N-H bond were used, suppressed edge roll off of silicon wafers and achieved a better edge roll off reduction effect compared to Comparative Examples 1 to 4. From these results, it can be confirmed that the amount of edge roll off can be reduced by using the above-mentioned nitrogen-containing water-soluble polymer that does not have a N-H bond.

Specific examples of the present invention have been explained in detail above, but these are merely examples, and do not limit the scope of the claims. The features set forth in the claims also encompass embodiments obtained by variously modifying or altering the specific examples shown above.

## Claims

1. A polishing composition, comprising an abrasive, a basic compound, a nitrogen-containing water-soluble polymer, and water, wherein

   the nitrogen-containing water-soluble polymer does not have a N-H bond in the molecule.

2. The polishing composition according to claim 1, wherein the nitrogen-containing water-soluble polymer has a constituent unit A in the main chain, and

   the constituent unit A includes at least one structure selected from a group consisting of an amide structure, an azole structure, a lactam structure, a morpholine structure, and an amidine structure.

3. The polishing composition according to claim 2, wherein a proportion of the amide structure relative to the total mass of the constituent unit A is 30 mass% or less.

4. The polishing composition according to claim 3, wherein the nitrogen-containing water-soluble polymer is polyacryloylmorpholine.

5. The polishing composition according to claim 3, wherein the nitrogen-containing water-soluble polymer is polyvinylimidazole.

6. The polishing composition according to any one of claims 1 to 5, wherein the abrasive is silica particles.

7. The polishing composition according to any one of claims 1 to 6, wherein the polishing composition is used to polish silicon.

## INTERNATIONAL SEARCH REPORT

| International application No. |
| --- |
| PCT/JP2018/009865 |

**A. CLASSIFICATION OF SUBJECT MATTER**
Int.Cl. H01L21/304(2006.01)i, B24B37/00(2012.01)i, C09K3/14(2006.01)i

According to International Patent Classification (IPC) or to both national classification and IPC

**B. FIELDS SEARCHED**

Minimum documentation searched (classification system followed by classification symbols)
Int.Cl. H01L21/304, B24B37/00, C09K3/14

Documentation searched other than minimum documentation to the extent that such documents are included in the fields searched
Published examined utility model applications of Japan 1922-1996
Published unexamined utility model applications of Japan 1971-2018
Registered utility model specifications of Japan 1996-2018
Published registered utility model applications of Japan 1994-2018

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>A | JP 2015-174918 A (NITTA HAAS INC.) 05 October 2015, paragraphs [0007]-[0018], [0041] (Family: none) | 1, 6-7<br>2-5 |
| X<br>A | JP 5007062 B2 (FUJIFILM CORPORATION) 22 August 2012, paragraphs [0008], [0011]-[0013], [0020], [0074], [0080], [0082] (Family: none) | 1-4, 6-7<br>5 |

☒ Further documents are listed in the continuation of Box C. ☐ See patent family annex.

| | | |
| --- | --- | --- |
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
| --- | --- |
| 14.05.2018 | 29.05.2018 |

| Name and mailing address of the ISA/ | Authorized officer |
| --- | --- |
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.

PCT/JP2018/009865

C (Continuation). DOCUMENTS CONSIDERED TO BE RELEVANT

| Category* | Citation of document, with indication, where appropriate, of the relevant passages | Relevant to claim No. |
|---|---|---|
| X<br>A | JP 2013-165173 A (FUJIMI INCORPORATED) 22 August 2013, paragraphs [0060], [0074]-[0076], [0083]<br>& US 2015/0014579 A1, paragraphs [0072], [0092]-[0095], [0101] & WO 2013/118710 A1 & DE 112013000912 T5 & TW 201343884 A & KR 10-2014-0130156 A | 1-3, 6-7<br>4-5 |
| X | JP 6068647 B2 (FUJIMI INCORPORATED) 25 January 2017, paragraphs [0009], [0031], [0032], [0051]-[0055], [0069], [0072], [0073]<br>& US 2016/0189973 A1, paragraphs [0009], [0032], [0033], [0052]-[0056], [0073], [0074] & WO 2015/019706 A1 & DE 112014003673 T5 & TW 201512381 A & CN 105451940 A & KR 10-2016-0041911 A | 1-7 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017072667 A
- WO 2011135949 A
- WO 2012005289 A
- JP 2016124943 A
- JP 2014216464 A